# EUROPEAN PATENT APPLICATION

(11) **EP 3 989 682 A1**
(43) Date of publication of application: **27.04.2022**
(21) Application number: 20826514.0
(22) Date of filing: 22.05.2020
(51) Int. Cl.: H05H 1/46, H01L 21/3065

(54) **PLASMA ETCHING METHOD**

(30) Priority: 18.06.2019 JP 2019113023
(71) Applicant: Showa Denko K.K., Tokyo 105-8518 (JP)
(72) Inventor: SATO, Daisuke, Tokyo 105-8518 (JP); KAIBUKI, Kaoru, Tokyo 105-8518 (JP); OKA, Yuki, Tokyo 105-8518 (JP)
(74) Representative: Strehl Schübel-Hopf & Partner
(86) International application number: PCT/JP2020/020404
(87) International publication number: WO 2020/255631

(57) **Abstract**

There is provided a plasma etching method having a high etching rate of a silicon nitride film. A plasma etching method includes an etching step of etching a silicon nitride film formed on a substrate (20) using plasma obtained by converting an etching gas containing iodine heptafluoride into plasma.

## Description

### Technical Field

The present invention relates to a plasma etching method.

### Background Art

In a semiconductor manufacturing process, a silicon nitride film is etched by plasma etching using an etching gas in some cases. For example, PTL 1 discloses a plasma etching method including etching a silicon nitride film by converting an etching gas containing fluoride gas, such as sulfur hexafluoride (SF₆), into plasma.

### Citation List

### Patent Literature

PTL 1: JP 2016-157940 A

### Summary of Invention

### Technical Problem

In a plasma etching method for use in a semiconductor manufacturing process and the like, a further improvement of the etching rate of a silicon nitride film has been desired.

It is an object of the present invention to provide a plasma etching method having a high etching rate of a silicon nitride film.

### Solution to Problem

In order to achieve the above-described object, one aspect of the present invention is as described in [1] to [7] below.
[1] A plasma etching method including an etching step of etching a silicon nitride film formed on a substrate using plasma obtained by converting an etching gas containing iodine heptafluoride into plasma.
[2] The plasma etching method according to [1], in which a silicon oxide film is formed together with the silicon nitride film on the substrate and the silicon oxide film is etched together with the silicon nitride film.
[3] The plasma etching method according to [2], in which the etching rate of the silicon nitride film is higher than the etching rate of the silicon oxide film.
[4] The plasma etching method according to [3], in which a ratio of the etching rate of the silicon nitride film to the etching rate of the silicon oxide film is 2 or more and 70 or less.
[5] The plasma etching method according to any one of [1] to [4], in which the etching gas is a mixed gas containing iodine heptafluoride and an inert gas.
[6] The plasma etching method according to any one of [1] to [5] including performing etching under a process pressure of 1 Pa or more and 10 Pa or less.
[7] The plasma etching method according to any one of [1] to [6] including performing etching while applying a bias power of 0 W or more and 1500 W or less to a lower electrode supporting the substrate.

### Advantageous Effects of Invention

The present invention provides a plasma etching method having a high etching rate of a silicon nitride film.

### Brief Description of Drawings

FIG. 1 is a schematic diagram of an example of a plasma etching apparatus illustrating one embodiment of a plasma etching method according to the present invention;
FIG. 2 is a graph illustrating the relationship between the process pressure and the Si₃N₄/SiO₂ selection ratio;
FIG. 3 is graph illustrating the relationship between the bias power and the Si₃N₄/SiO₂ selection ratio at a process pressure of 3 Pa;
FIG. 4 is graph illustrating the relationship between the bias power and the Si₃N₄/SiO₂ selection ratio at a process pressure of 5 Pa; and
FIG. 5 is graph illustrating the relationship between the concentration of iodine heptafluoride in an etching gas and the Si₃N₄/SiO₂ selection ratio.

### Description of Embodiments

One embodiment of the present invention will now be described below. This embodiment is an example of the present invention, and the present invention is not limited to this embodiment. Further, this embodiment can be variously altered or modified and embodiments obtained by such alternations or modifications may also be included in the present invention.

A plasma etching method of this embodiment includes an etching step of etching a silicon nitride film (for example, Si₃N₄ film) formed on a substrate using plasma obtained by converting an etching gas containing iodine heptafluoride (IF₇) into plasma. By performing plasma etching using the etching gas containing iodine heptafluoride, the silicon nitride film can be etched at a high etching rate.

According to the plasma etching method of this embodiment, a silicon oxide film (for example, SiO₂ film) can also be etched together with the silicon nitride film. More specifically, when a substrate on which a silicon nitride film and a silicon oxide film are formed is etched by the plasma etching method of this embodiment, the silicon nitride film and the silicon oxide film can be simultaneously etched.

At this time, the silicon nitride film can be etched at an etching rate higher than that of the silicon oxide film. More specifically, according to the plasma etching method of this embodiment, the silicon nitride film can be selectively plasma etched with respect to the silicon oxide film. For example, the silicon nitride film and the silicon oxide film can be etched such that a ratio of the etching rate of the silicon nitride film to the etching rate of the silicon oxide film is 2 or more and 70 or less, and, from the viewpoint of more stable control of the etching, 3 or more and 30 or less.

Therefore, when the plasma etching method of this embodiment is applied to a semiconductor manufacturing process, the silicon nitride film can be efficiently selectively removed in etching processing for the formation of shallow trench isolation (STI) using double patterning. Further, when the etching selectivity of the silicon nitride film to the silicon oxide film is improved (the ratio of the etching rate of the silicon nitride film to the etching rate of the silicon oxide film is increased), the plasma etching method can be used as an alternative method for a wet etching method.

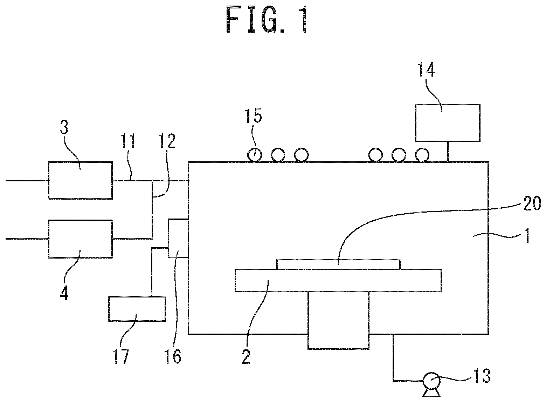

The plasma etching by the plasma etching method of this embodiment can be performed using a plasma etching apparatus. The plasma source in the plasma etching apparatus is not particularly limited and, for example, high-frequency discharge plasma, such as inductively coupled plasma (ICP) and capacitively coupled plasma (CCP), and microwave discharge plasma, such as electron cyclotron resonance plasma (ECRP), are mentioned. A plasma etching apparatus in FIG. 1 described in detail later is a plasma etching apparatus using the ICP as the plasma source.

In the plasma etching method of this embodiment, the plasma etching is preferably performed under a process pressure of 0.2 Pa or more and 26.7 Pa or less, more preferably performed under a process pressure of 1 Pa or more and 15 Pa or less, still more preferably performed under a process pressure of 1 Pa or more and 10 Pa or less, and particularly preferably performed under a process pressure of 3 Pa or more and 7 Pa or less. The higher the process pressure is, the more the dissociation of the iodine heptafluoride is promoted, and therefore the etching selectivity of the silicon nitride film to the silicon oxide film is improved. The higher the process pressure is, the higher the ignitability of plasma is.

The etching gas may contain only iodine heptafluoride, but may be a mixed gas containing iodine heptafluoride and an inert gas. The kind of the inert gas is not particularly limited. Examples of the inert gas include helium, argon, neon, krypton, xenon, and nitrogen gas. These inert gases may be used alone or in combination of two or more kinds thereof.

The mixing ratio of the iodine heptafluoride and the inert gas may be adjusted considering the ignitability of plasma. The concentration of the iodine heptafluoride in the etching gas can be set to more than 0 vol% and 100 vol% or less and is more preferably set to 5 vol% or more and 50 vol% or less in order to obtain more sufficient ignitability of plasma and is still more preferably set to 10 vol% or more and 30 vol% or less in order to sufficiently increase the etching selectivity of the silicon nitride film to the silicon oxide film.

The use amount of the etching gas, e.g., the total flow rate of the etching gas into a chamber where the plasma etching is performed in the plasma etching apparatus, may be adjusted according to the volume, the exhaust capacity, process pressure, and the like of the chamber.

The plasma etching apparatus can generate plasma by converting an etching gas into plasma by applying a high frequency source power to a radio frequency (RF) coil to form an electric field and a magnetic field, for example. The magnitude of the source power is not particularly limited and is preferably set to more than 0 W and 3000 W or less, more preferably set to 100 W or more and 1500 W or less, and still more preferably set to 200 W or more and 1000 W or less.

The higher the source power is, the more the dissociation of iodine heptafluoride is promoted and the higher the etching rate is. Therefore, the magnitude of the source power may be set according to a desired etching rate. When the magnitude of the source power is in the numerical ranges above, the etching rate of the silicon nitride film is sufficiently high and the etching selectivity of the silicon nitride film to the silicon oxide film is sufficiently high.

The temperature of the substrate in the plasma etching is not particularly limited and is preferably set to -20°C or more and 250°C or less, more preferably set to 0°C or more and 100°C or less, and still more preferably set to 20°C or more and 70°C or less. When the temperature of the substrate in the plasma etching is in the numerical ranges above, a deformation due to alteration, sublimation, and the like of a resist film formed on the substrate is suppressed, and therefore the plasma etching can be performed with high patterning accuracy.

In the plasma etching, a bias power may be applied to a lower electrode supporting the substrate. More specifically, the magnitude of the bias power applied to the lower electrode may be 0 W or may exceed 0 W. In order to sufficiently increase the etching selectivity of the silicon nitride film to the silicon oxide film, the bias power applied to the lower electrode is preferably set to 12000 W or less, more preferably set to 1500 W or less, and still more preferably set to 300 W or less.

Hereinafter, an example of performing the plasma etching of the silicon nitride film and the silicon oxide film formed on the surface of the substrate using the plasma etching apparatus illustrated in FIG. 1 is described below. The plasma etching apparatus in FIG. 1 is a plasma etching apparatus using ICP as the plasma source. First, the plasma etching apparatus in FIG. 1 is described.

The plasma etching apparatus in FIG. 1 includes a chamber 1 where plasma etching is performed thereinside, a lower electrode 2 supporting a substrate 20 to be subjected to plasma etching inside the chamber 1, a power supply for bias power (not illustrated) applying a bias power to the lower electrode 2, an RF coil 15 forming an electric field and a magnetic field for converting an etching gas into plasma inside the chamber 1, a power supply for source power (not illustrated) applying a high frequency source power to the RF coil 15, a vacuum pump 13 reducing the pressure inside the chamber 1, a pressure gauge 14 measuring the pressure inside the chamber 1, a sensor 16 capturing plasma emission generated with the generation of plasma, and a spectroscope 17 spectrally separating the plasma emission captured by the sensor 16 and monitoring temporal changes of the plasma emission.

On the surface of the substrate 20, a silicon nitride film and a silicon oxide film are formed. As the sensor 16, a CCD (Charge-Coupled Device) image sensor is usable, for example. Instead of providing the sensor 16 and the spectroscope 17, an observation hole may be provided in the chamber 1 to visually observe the inside of the chamber 1 from the observation hole and confirm the temporal changes of the plasma emission.

The chamber 1 includes an etching gas supply unit supplying an etching gas into the chamber 1. The etching gas supply unit has an iodine heptafluoride gas supply unit 3 supplying iodine heptafluoride gas, an inert gas supply unit 4 supplying an inert gas, etching gas supply piping 11 connecting the iodine heptafluoride gas supply unit 3 and the chamber 1, and inert gas supply piping 12 connecting the inert gas supply unit 4 to an intermediate part of the etching gas supply piping 11.

When the iodine heptafluoride gas is supplied as the etching gas to the chamber 1, the iodine heptafluoride gas is sent to the etching gas supply piping 11 from the iodine heptafluoride gas supply unit 3, so that the iodine heptafluoride gas is supplied to the chamber 1 through the etching gas supply piping 11.

When a mixed gas of the iodine heptafluoride gas and an inert gas is applied as the etching gas, the iodine heptafluoride gas is sent from the iodine heptafluoride gas supply unit 3 to the etching gas supply piping 11 and the inert gas is sent from the inert gas supply unit 4 to the etching gas supply piping 11 through the inert gas supply piping 12. Thus, the iodine heptafluoride gas and the inert gas are mixed at the intermediate part of the etching gas supply piping 11 to form a mixed gas, and the mixed gas is supplied to the chamber 1 through the etching gas supply piping 11.

When the plasma etching is performed using such a plasma etching apparatus, the substrate 20 is placed on the lower electrode 2 arranged inside the chamber 1, the pressure inside the chamber 1 is reduced to 1 Pa or more and 10 Pa or less by the vacuum pump 13, and then the etching gas is supplied into the chamber 1 by the etching gas supply unit. Then, when a high frequency (for example, 13.56 MHz) source power is applied to the RF coil 15, an electric field and a magnetic field are formed inside the chamber 1 to thereby accelerate electrons, and the accelerated electrons collide with iodine heptafluoride molecules in the etching gas to newly generate ions and electrons, resulting in an electric discharge and the formation of plasma. The generation of the plasma can be confirmed using the sensor 16 and the spectroscope 17.

When the plasma is generated, the silicon nitride film and the silicon oxide film formed on the surface of the substrate 20 are etched.

The supply amount of the etching gas to the chamber 1 and the concentration of the iodine heptafluoride in the etching gas (mixed gas) can be adjusted by controlling the flow rates of the iodine heptafluoride gas and the inert gas with mass flow controllers (not illustrated) installed in the etching gas supply piping 11 and the inert gas supply piping 12, respectively.

As described above, under the conditions where the iodine heptafluoride or the mixed gas of the iodine heptafluoride and the inert gas is used as the etching gas, the process pressure is set to 1 Pa or more and 10 Pa or less, and the bias power is set to 1500 W or less, the silicon nitride film and the silicon oxide film can be etched such that the ratio of the etching rate of the silicon nitride film to the etching rate of the silicon oxide film is 2 or more and 70 or less or, from the viewpoint of more stable control of the etching, 3 or more and 30 or less.

### EXAMPLES

The present invention is described in more detail by illustrating Examples and Comparative Examples below.

### (Example 1)

Plasma etching of a substrate was performed using an ICP etching apparatus RIE-200iP manufactured by Samco Inc., having substantially the same configuration as the plasma etching apparatus in FIG. 1. This substrate is obtained by forming a silicon nitride film (Si₃N₄ film) and a silicon oxide film (SiO₂ film) on a silicon substrate by a chemical vapor deposition method.

The internal volume of a chamber is 46000 cm³ and the etching gas is a mixed gas of iodine heptafluoride gas and argon. The flow rate of the iodine heptafluoride gas was set to 10 sccm and the flow rate of the argon was set to 40 seem, thereby adjusting the concentration of the iodine heptafluoride in the etching gas to 20 vol%. Herein, sccm is the volumetric flow rate (cm³) per minute standardized under the conditions of 0°C and 1 atm.

The process pressure inside the chamber was set to 1 Pa, the source power was set to 500 W, the bias power was set to 0 W, and the temperature of the substrate was set to 20°C. Then, the plasma etching was performed while constantly monitoring the flow rate of the iodine heptafluoride gas, the flow rate of the argon, the process pressure, the source power, and the bias power to confirm that there were no differences between the set values and executed values thereof. The results are illustrated in Table 1.

Table 1 illustrates a period of time while the silicon nitride film and the silicon oxide film were plasma etched (etching time), the film thicknesses before etching and the film thicknesses after etching of the silicon nitride film and the silicon oxide film, the etching rates of the silicon nitride film and the silicon oxide film, and a ratio of the etching rate of the silicon nitride film to the etching rate of the silicon oxide film (Si₃N_{4/}SiO₂ selection ratio).

The film thicknesses of the silicon nitride film and the silicon oxide film were measured using a reflectance spectroscopic film thickness meter F20 manufactured by Filmetrics Japan, Inc. The etching rate of each of the silicon nitride film and the silicon oxide film was calculated by subtracting the film thickness after etching from the film thickness before etching, followed by dividing by the etching time.

**[Table 1]**

| | Etching gas | Process pressure (Pa) | Etching time (min) | | Film thickness before etching (nm) | | Film thickness after etching (nm) | | Etching rate (nm/min) | | Si₃N₄/SiO₂ selection ratio |
|---|---|---|---|---|---|---|---|---|---|---|---|
| | | | SiO₂ | Si₃N₄ | SiO₂ | Si₃N₄ | SiO₂ | Si₃N₄ | SiO₂ | Si₃N₄ | |
| Ex. 1 | IF₇/Ar | 1 | 1.00 | 0.50 | 1466 | 500 | 1423 | 396 | 42.9 | 208.3 | 4.85 |
| Ex. 2 | | 3 | 3.00 | 1.00 | 1450 | 492 | 1378 | 238 | 24.1 | 254.2 | 10.56 |
| Ex. 3 | | 5 | 1.00 | 0.50 | 1453 | 499 | 1437 | 353 | 16.0 | 293.6 | 18.37 |
| Ex. 4 | | 7 | 1.50 | 0.50 | 1455 | 499 | 1442 | 357 | 8.9 | 283.6 | 31.83 |
| Comp. Ex.1 | SF₆/Ar | 1 | 2.00 | 0.50 | 1443 | 500 | 1362 | 423 | 40.6 | 154.8 | 3.82 |
| Comp. Ex. 2 | | 3 | 2.00 | 0.50 | 1455 | 502 | 1368 | 386 | 43.4 | 230.2 | 5.31 |
| Comp. Ex. 3 | | 5 | 2.00 | 0.50 | 1446 | 499 | 1369 | 360 | 38.6 | 278.8 | 7.23 |
| Comp. Ex. 4 | | 7 | 2.00 | 0.50 | 1635 | 501 | 1587 | 385 | 24.1 | 231.2 | 9.58 |

### (Examples 2 to 4)

The plasma etching was performed in the same manner as in Example 1, except that the process pressure was changed as illustrated in Table 1, and then the etching rates of the silicon nitride film and the silicon oxide film and the ratio of the etching rate of the silicon nitride film to the etching rate of the silicon oxide film were calculated. The results are illustrated in Table 1.

### (Comparative Examples 1 to 4)

The plasma etching was performed in the same manner as in Example 1, except that the etching gas was set to a mixed gas of a sulfur hexafluoride gas and argon (sulfur hexafluoride concentration in the etching gas: 20 vol%) and the process pressure was changed as illustrated in Table 1, and then the etching rates of the silicon nitride film and the silicon oxide film and the ratio of the etching rate of the silicon nitride film to the etching rate of the silicon oxide film were calculated. The results are illustrated in Table 1.

### (Examples 11 to 18)

The plasma etching was performed in the same manner as in Example 1, except that the process pressure was set to 3 Pa and the bias power was changed as illustrated in Table 2, and then the etching rates of the silicon nitride film and the silicon oxide film and the ratio of the etching rate of the silicon nitride film to the etching rate of the silicon oxide film were calculated. The results are illustrated in Table 2.

**[Table 2]**

| | Etching gas | Bias power (W) | Etching time (min) | | Film thickness before etching (nm) | | Film thickness after etching (nm) | | Etching rate (nm/min) | | Si₃N₄/SiO₂ selection ratio |
|---|---|---|---|---|---|---|---|---|---|---|---|
| | | | SiO₂ | Si₃N₄ | SiO₂ | Si₃N₄ | SiO₂ | Si₃N₄ | SiO₂ | Si₃N₄ | |
| Ex. 11 | IF₇/Ar | 0 | 3.00 | 1.00 | 1450 | 492 | 1377 | 238 | 24.4 | 254.2 | 10.40 |
| Ex. 12 | | 20 | 3.00 | 0.75 | 1445 | 495 | 1327 | 256 | 39.4 | 318.0 | 8.06 |
| Ex. 13 | | 40 | 3.00 | 0.75 | 1443 | 493 | 1267 | 220 | 58.9 | 364.4 | 6.19 |
| Ex. 14 | | 60 | 2.00 | 0.42 | 1422 | 495 | 1258 | 298 | 82.2 | 474.1 | 5.77 |
| Ex. 15 | | 80 | 2.00 | 0.42 | 1428 | 492 | 1221 | 272 | 103.3 | 528.3 | 5.11 |
| Ex. 16 | | 100 | 1.00 | 0.50 | 1450 | 489 | 1285 | 189 | 165.0 | 599.0 | 3.63 |
| Ex. 17 | | 150 | 2.00 | 0.42 | 1440 | 494 | 1126 | 248 | 157.2 | 588.3 | 3.74 |
| Ex. 18 | | 270 | 1.50 | 0.42 | 1440 | 495 | 1044 | 213 | 263.9 | 677.6 | 2.57 |

### (Examples 21 to 24)

The plasma etching was performed in the same manner as in Example 1, except that the process pressure was set to 5 Pa and the bias power was changed as illustrated in Table 3, and then the etching rates of the silicon nitride film and the silicon oxide film and the ratio of the etching rate of the silicon nitride film to the etching rate of the silicon oxide film were calculated. The results are illustrated in Table 3.

**[Table 3]**

| | Etching gas | Bias power (W) | Etching time (min) | | Film thickness before etching (nm) | | Film thickness after etching (nm) | | Etching rate (nm/min) | | Si₃N₄/SiO₂ selection ratio |
|---|---|---|---|---|---|---|---|---|---|---|---|
| | | | SiO₂ | Si₃N₄ | SiO₂ | Si₃N₄ | SiO₂ | Si₃N₄ | SiO₂ | Si₃N₄ | |
| Ex. 21 | IF₇/Ar | 0 | 1.17 | 0.50 | 1456 | 500 | 1437 | 353 | 15.9 | 293.6 | 18.49 |
| Ex. 22 | | 40 | 1.00 | 0.50 | 1454 | 502 | 1395 | 264 | 58.7 | 477.2 | 8.13 |
| Ex. 23 | | 100 | 1.50 | 0.50 | 1432 | 493 | 1237 | 149 | 130.4 | 689.1 | 5.29 |
| Ex. 24 | | 270 | 1.00 | 0.33 | 1460 | 498 | 1241 | 204 | 218.4 | 879.7 | 4.03 |
| Comp. Ex. 21 | SF₆/Ar | 0 | 2.00 | 0.50 | 1446 | 499 | 1369 | 360 | 38.6 | 278.8 | 7.23 |
| Comp. Ex. 22 | | 100 | 2.00 | 0.42 | 1462 | 503 | 1222 | 267 | 120.1 | 566.5 | 4.72 |
| Comp. Ex. 23 | | 270 | 2.00 | 0.42 | 1456 | 498 | 800 | 150 | 327.8 | 834.9 | 2.55 |

### (Comparative Examples 21 to 23)

The plasma etching was performed in the same manner as in Example 1, except that the etching gas was set to a mixed gas of a sulfur hexafluoride gas and argon (sulfur hexafluoride concentration in the etching gas: 20 vol%), the process pressure was set to 5 Pa, and the bias power was changed as illustrated in Table 3, and then the etching rates of the silicon nitride film and the silicon oxide film and the ratio of the etching rate of the silicon nitride film to the etching rate of the silicon oxide film were calculated. The results are illustrated in Table 3.

### (Examples 31 to 33)

The plasma etching was performed in the same manner as in Example 1, except that the process pressure was set to 3 Pa and the concentration of iodine heptafluoride in an etching gas was changed as illustrated in Table 4, and then the etching rates of the silicon nitride film and the silicon oxide film and the ratio of the etching rate of the silicon nitride film to the etching rate of the silicon oxide film were calculated. The results are illustrated in Table 4.

In Examples 31 to 33, the concentration of the iodine heptafluoride in the etching gas was adjusted by setting the flow rates of the iodine heptafluoride gas and the argon as follows. More specifically, the flow rate of the iodine heptafluoride gas was set to 2.5 sccm and the flow rate of the argon was set to 47.5 seem, thereby adjusting the concentration of the iodine heptafluoride in the etching gas to 5 vol%. The flow rate of the iodine heptafluoride gas was set to 5 sccm and the flow rate of the argon was set to 45 seem, thereby adjusting the concentration of the iodine heptafluoride in the etching gas to 10 vol%. The flow rate of the iodine heptafluoride gas was set to 10 sccm and the flow rate of the argon was set to 40 seem, thereby adjusting the concentration of the iodine heptafluoride in the etching gas was adjusted to 20 vol%.

**[Table 4]**

| | Etching gas | IF₇ concentration (vol%) | Etching time (min) | | Film thickness before etching (nm) | | Film thickness after etching (nm) | | Etching rate (nm/min) | | Si₃N₄/SiO₂ selection ratio |
|---|---|---|---|---|---|---|---|---|---|---|---|
| | | | SiO₂ | Si₃N₄ | SiO₂ | Si₃N₄ | SiO₂ | Si₃N₄ | SiO₂ | Si₃N₄ | |
| Ex. 31 | IF₇/Ar | 5 | 2.00 | 1.00 | 1964 | 499 | 1815 | 303 | 74.5 | 196.4 | 2.64 |
| Ex. 32 | | 10 | 1.00 | 0.50 | 1440 | 498 | 1318 | 256 | 121.1 | 484.5 | 4.00 |
| Ex. 33 | | 20 | 1.00 | 0.50 | 1450 | 489 | 1285 | 189 | 165.0 | 599.0 | 3.63 |

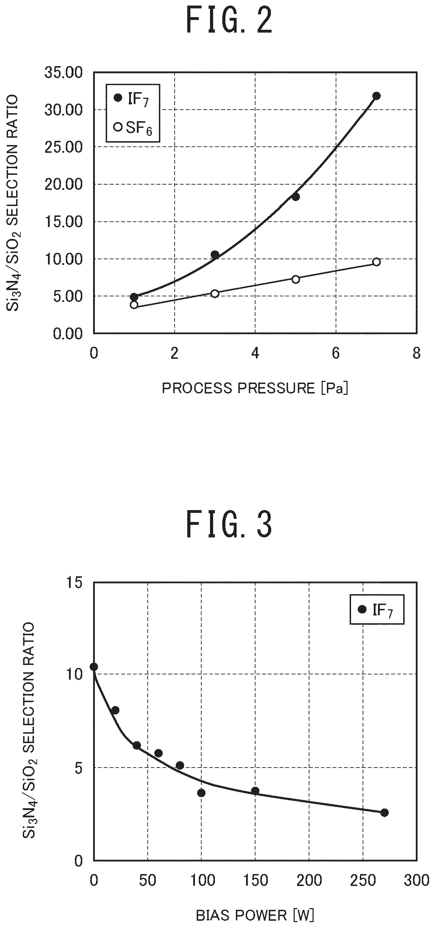

The results of Tables 1 to 4 are illustrated in the graphs of FIGS. 2 to 5, respectively. Table 1 and the graph in FIG. 2 show that the ratio of the etching rate of the silicon nitride film to the etching rate of the silicon oxide film (Si₃N₄/SiO₂ selection ratio) is larger in the etching gas containing iodine heptafluoride than in the etching gas containing sulfur hexafluoride at any process pressure and the silicon nitride film is selectively etched with respect to the silicon oxide film. It is found that, when the process pressure is higher, the Si₃N₄/SiO₂ selection ratio is further improved.

Table 2 and the graph in FIG. 3 show that, when the bias power is lower, the Si₃N₄/SiO₂ selection ratio is further improved.

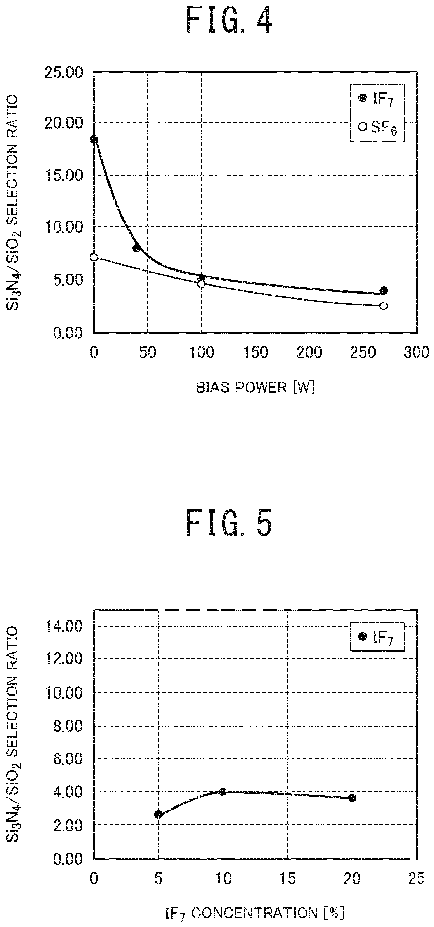

Table 3 and the graph in FIG. 4 show that the ratio of the etching rate of the silicon nitride film to the etching rate of the silicon oxide film is larger in the etching gas containing iodine heptafluoride than in the etching gas containing sulfur hexafluoride at any bias power and the silicon nitride film is selectively etched with respect to the silicon oxide film. It is found that, when the bias power is lower, the Si₃N₄/SiO₂ selection ratio is further improved.

Table 4 shows that, when the concentration of the iodine heptafluoride in the etching gas is higher, the etching rate is higher with respect to both the silicon oxide film and the silicon nitride film. On the other hand, Table 4 and the graph in FIG. 5 show that the Si₃N₄/SiO₂ selection ratio tends to be higher when the concentration of the iodine heptafluoride in the etching gas is higher, but there were no significant changes.

### Reference Signs List

- 1: chamber
- 2: lower electrode
- 3: iodine heptafluoride gas supply unit
- 4: inert gas supply unit
- 11: etching gas supply piping
- 12: inert gas supply piping
- 13: vacuum pump
- 14: pressure gauge
- 15: RF coil
- 16: sensor
- 17: spectroscope
- 20: substrate

## Claims

1. A plasma etching method comprising:
an etching step of etching a silicon nitride film formed on a substrate using plasma obtained by converting an etching gas containing iodine heptafluoride into plasma.

2. The plasma etching method according to claim 1, wherein a silicon oxide film is formed together with the silicon nitride film on the substrate and the silicon oxide film is etched together with the silicon nitride film.

3. The plasma etching method according to claim 2, wherein an etching rate of the silicon nitride film is higher than an etching rate of the silicon oxide film.

4. The plasma etching method according to claim 3, wherein a ratio of the etching rate of the silicon nitride film to the etching rate of the silicon oxide film is 2 or more and 70 or less.

5. The plasma etching method according to any one of claims 1 to 4, wherein the etching gas is a mixed gas containing iodine heptafluoride and an inert gas

6. The plasma etching method according to any one of claims 1 to 5 comprising:
performing etching under a process pressure of 1 Pa or more and 10 Pa or less.

7. The plasma etching method according to any one of claims 1 to 6 comprising:
performing etching while applying a bias power of 0 W or more and 1500 W or less to a lower electrode supporting the substrate.
